# EUROPÄISCHE PATENTSCHRIFT

(11) **EP 2 606 227 B1**
(45) Veröffentlichungstag und Bekanntmachung des Hinweises auf die Patenterteilung: **17.01.2018**
(21) Anmeldenummer: 11743432.4
(22) Anmeldetag: 05.07.2011
(51) Int. Cl.: F03D 80/00, H02B 1/40, H02B 1/46, H05K 5/00, F03D 80/80

(54) **MIT EINEM DECKEL VERSCHLOSSENER KASTENFÖRMIGER ELEKTRISCHER SCHALTSCHRANK FÜR EINE WINDENERGIEANLAGE**
BOX-SHAPED ELECTRIC CONTROL CABINET WHICH CAN BE CLOSED BY A COVER, FOR A WIND ENERGY POWER PLANT
ARMOIRE DE COMMANDE ÉLECTRIQUE EN FORME DE CAISSE FERMÉE PAR UN COUVERCLE POUR UNE ÉOLIENNE

(30) Priorität: 19.08.2010 DE 102010034873
(43) Veröffentlichungstag der Anmeldung: 26.06.2013
(73) Patentinhaber: SSB Wind Systems GmbH & Co. KG, 48499 Salzbergen (DE)
(72) Erfinder: THIER, Mark-Andre, 59387 Ascheberg (DE)
(86) Internationale Anmeldenummer: PCT/EP2011/003339
(87) Internationale Veröffentlichungsnummer: WO 2012/022394

(56) Entgegenhaltungen:
- EP-A1- 0 810 701
- WO-A2-2011/032897
- DE-A1- 10 241 574
- DE-A1- 19 639 889
- DE-A1- 19 743 974
- DE-A1-102006 009 127
- DE-U1- 29 818 507
- FR-A1- 2 300 442

## Beschreibung

Die Erfindung betrifft einen mit einem Deckel verschlossenen kastenförmigen elektrischen Schaltschrank einer Windenergieanlage nach dem Oberbegriff des Anspruches 1. Die Erfindung betrifft insbesondere die geometrische Anordnung und Tauschbarkeit der Schaltschranksegmente. Die Erfindung betrifft auch eine Windenergieanlage mit einem Deckel verschlossenen kastenförmigem Schaltschrank.

Moderne Windenergieanlagen umfassen drehbar an einem Rotor gelagerte Rotorblätter, wobei durch eine individuelle Änderung des Blattwinkels relativ für jedes Rotorblatt ein Anströmwinkel des Windes variiert werden kann. Die Veränderung erfolgt durch einen Pitchantrieb, der mit einem externen Stromnetz verbunden ist und einen steuerbaren Elektromotor umfasst, dem Steuer und Regeleinrichtungen zur Verstellung des Rotorblattes sowie einem Umrichter zugeordnet sind, die in einem elektrischen Schaltschrank (Pitchschaltschrank) angeordnet sind. Wesentliche Bestandteile eines Pitchschaltschrankes sind elektronische Umrichtereinheiten für den gesteuerten Antrieb des Pitchsystems. Daher wird ein solcher Schrank auch als Umrichterbox bezeichnet. Eine Umrichterbox umfasst z. B. elektrische oder elektronische Bauteile und Geräte, wie z.B. Netzteile, Leistungsschalter und Stecker, Ein- /Ausgabeeinheiten, Sicherungen, Transformatoren und andere Teile und Geräte, die auch in einem klassischen Schaltschrank für einen elektrischen Antrieb vorgesehen sind.

Jedem Blatt (Achse) ist meist ein eigener Pitchantrieb mit einem zugehörigen Steuerschrank zugeordnet, so dass in einer Windenergieanlage (WEA) mehrere Pitchschaltschränke vorgesehen sind, die meist am oberen Mastende (Topbox) der Anlage angeordnet und als mit einem Deckel versehenden geschlossenen kompakten Kasten (Box) ausgeführt sind . Sie sind dort entweder im rotierenden Teil (Nabe) und / oder im feststehenden Teil der Anlage (Gondel) angeordnet, wobei sie jedoch bevorzugt in der Nähe des Lagers des Rotorblattes in der Nabe angeordnet sind. Soll die Steuerung des Pitchsystems koordiniert für mehrere Achsen ablaufen, kann zusätzlich noch ein sogenannter Leit-Steuerschrank (Leitbox) in der Nabe oder auch in der Gondel vorgesehen werden, der mit den zugehörigen Achsboxen verschaltet ist.

Auf Grund des Aufstellungsortes und des Einbauortes sind diese Kästen besonders extremen Witterungsbedingungen ausgesetzt.

Bei Netzstörungen oder Netzausfall muss sichergestellt werden, dass die Spannungsversorgung des Pitchantriebes zumindest für kurze Zeit aufrechterhalten bleibt. Daher weist jeder Pitchantrieb ebenfalls im Rotor oder in der Gondel angeordnete zusätzliche Gleichspannungsquellen in Form von Akkumulatoren oder wieder aufladbaren Kondensatoren auf, die direkt mit der jeweiligen Antriebseinheit (Umrichter + Motor) verbunden sind. Diese Spannungsquelle sorgt dafür, dass bei Ausfall der Netzversorgung die Energieversorgung des Pitchantriebes mindestens für eine bestimmte Zeit aufrechterhalten bleibt. Durch eine Stellbewegung des Motors wird das jeweilige Rotorblatt in die sog. Fahnen- bzw. Parkstellung gebracht und damit die Anlage abgeschaltet oder nur mit gesicherter Drehzahl (Fail-Safe Funktion) weiter betrieben. Auch die wieder aufladbaren Gleichspannungsquellen mit den zugehörigen Schaltungen sind auf Grund des Einbauortes in einem kastenförmigen Schrank (Akkubox) eingefasst, der meist in der Nähe der zugehörigen Achsbox angeordnet ist.

Umrichter- und Akkubox bilden somit eine Schaltschrankkombination aus zwei oder mehreren Schränken oder Kästen, die direkt miteinander verbunden oder benachbart angeordnet sind.

Eine Windenergieanlage mit drei Rotorblättern kann bis zu 7 Schaltschränke aufweisen, die je nach Anforderungen und Funktion unterschiedlich aufgebaut sind und jeweils einzeln gefertigt werden müssen. Die verschiedenen Schaltschränke werden heute zum Teil auch modulartig aufgebaut, d. h. die einzelnen Komponenten sind entsprechend ihrer Funktion zusammengefasst und bilden jeweils entweder eine eigenes Modul oder Segment oder die Anordnung weist mehrere Modulgehäuse auf, die mechanisch und elektrisch miteinander verbunden sind.

Eine am Prioritätstag noch nicht veröffentlichte DE Patentanmeldung der Anmeldering mit der Publikationsnummer DE 10 2009 044 034 A1 zeigt eine Windenergieanlage mit einer elektrische Schaltschrankanordnung, in der eine Schaltung zum Betätigen mindestens eines Blattverstellantriebes (Pitchsysteme) vorgesehen ist, mittels dessen ein oder mehrere Rotorblätter der Windenergieanlage um ihre Blattachsen gedreht werden können. Die Schaltschrankanordnung umfasst mehrere Module, die zu einem kompakten und radial mittigen Behälter zusammengefasst sind, dessen Innenraum insbesondere durch Trennwände in mehrere Segmente (Module) unterteilt ist. Die Trennwände bilden mit der Wandung eines Segmentes einen Schaltschrank oder Modul, dem eine bestimmte Funktion zugeordnet ist. So ist ein Modul für die Funktion des Akkuschrankes, ein anderes für die des Umrichterschrankes, ein weiteres für die des Leitschrankes und ggf. weitere Module für andere Funktionen vorgesehen. Die einzelnen Module können jeweils eine separate bauliche Einheit bilden, die auch separat gefertigt werden können. Jedem Modul oder Wabe ist jedoch die oben erwähnte spezielle elektrische Funktion zugeordnet. Eine Austauschbarkeit der Funktionen ist bei den einzelnen Modulen nicht vorgesehen.

Aus dem allgemeinen Schaltschrankbau (z.B. DE 102 41 574 B4) sind modulartig aufgebaute Schaltschränke bekannt, die mehrere Modulgehäuse umfassen und über eine Verbindungselement mit einander verbunden sind. Die Modulgehäuse können jeweils über eine Reihe von elektrischen Steckverbindungen verfügen, die entweder nach außen geführt oder zur Verbindung der Modulgehäuse vorgesehen sind.

Aus der DE 197 43 974 A1 ist ein Schaltschrank mit einem Schaltschrankkasten mit mehreren auf einer Tragschiene befestigten Modulen bekannt, wobei jedem einzelnen Modul eine bestimmte Funktion zugeordnet ist. Der Schaltschrank ist lediglich funktionsblockorientiert und modular aufgebaut. Die Module unterscheiden sich nicht in ihrer technischen Funktion von einem klassischen Schaltschrank, sondern nur in ihrer einfacherem Ein- bzw. Ausbauweise.

Der wesentliche Nachteil der bekannten Lösungen besteht darin, dass bei steigender Anzahl der elektrischen Komponenten, bedingt durch technische Veränderungen an der Windenergieanlage, der Grundriss des Schaltschranks vergrößert werden muss. Ggf. muss ein weiterer Schrank oder ein Modul zu der bestehenden Schaltschrankanordnung hinzugefügt werden. Bedarf es eines höheren Ausstattungsrad, z. B. das zusätzliche oder größere Komponenten erforderlich werden, wird ein neuer Schrank konzipiert oder ein zusätzliches Gehäusemodul der vorhandenen Anordnung hinzugefügt.

Bei Gleichteilen oder Gleichfunktionen von Schaltschränken müssen daher bei veränderten technischen Anforderungen der Anlagenbetreiber jeweils immer neue Schaltschränke mit dem entsprechenden Inhalt konzipiert und gefertigt werden, die in Einzelfertigung bevorratet hergestellt und jeweils bestückt werden müssen. Dies macht die Schaltschrankfertigung teuer und aufwendig.

DE 196 39 889 A1) zeigt ein kastenartiges Gehäuse für einen elektrischen Schaltschrank mit einem Basisteil, das ein Bodenteil, Seitenteile und ein Verschlussteil umfasst, wobei mehrere aneinandergereihte Basisteile modulartig zu einem gemeinsamen Schaltschrankgehäuse zusammensetzbar sind. Durch diese Maßnahme ist der Schaltschrank bei Beibehaltung jedoch der ursprünglichen Funktion erweiterbar.

DE 298 18 507 U zeigt einen als elektrischen Verteilerschrank ausgebildeten Steuerschrank, der ein im wesentliche C-förmiges Modul Segment aufweist, an dem weitere C-förmige Grundmodule angefügt werden können, die somit zu einem vergrößerten Steuerschrank erweitert werden können. Die einzelnen Module können den Anforderungen entsprechend unterschiedlich breit ausgeführt werden.

D3 (EP 0 810 701 A1) zeigt einen modular aufgebauten elektrischen Steuerschrank, der sowohl für die an einer Wand hängend als auch auf einem Boden stehend verwendet werden. Der Schrank besteht aus einzelnen Modulen, die für beide Einsatzarten verbaut werden können.

D4 (FR 2300442 A1) zeigt einen aus mehreren Einzelteilen (Modulen) zusammensetzbaren elektrischen Schaltschrank. Ein einzelnes Modul besteht aus einer Bodenelement, jeweils zwei vertikalen Seitenelemente und einem Deckenelement sowie horizontale Zwischenwände, die zusammengefügt werden. Für die Erweiterung des Schaltschankrankes kann zwischen den beiden Seitenelemente eine vertikale Zwischenwand eingebaut werden.

Da in den heutigen Naben der Windenergieanlagen nicht unbegrenzt viel Platz vorhanden ist, muss immer das Optimum zwischen notwendigem Platz für elektrische Komponenten und der Größe der Nabe gefunden werden. Nicht selten lassen sich insbesondere Achsschränke nach der Montage in der Nabe nicht wieder entfernen, ohne die Blätter der WEA zu demontieren. Dies ist bei den geringen Platzverhältnissen in der Nabe mit erheblichem Aufwand verbunden oder meistens nicht möglich. Bei einem Totalausfall eines Pitchsystems, muss meist die Nabe, inklusive der Blätter von der Gondel abgenommen werden. Am Boden werden dann die Blätter demontiert, um durch die Blattlageröffnungen die Achsschaltschränke zu entnehmen und ggf. neue Schaltschränke oder Module einzubauen.

Die Aufgabe der Erfindung besteht darin, die Fertigung und Bestückung von Schaltschranken flexibel je nach technischen Anforderungen zu gestalten und zu verbessern. Ferner soll der Einbau bzw. die Demontage solcher Schaltschränke verbessert werden.

Die Aufgabe der Erfindung wird in Verbindung mit dem Oberbegriff des Anspruches 1 durch seine kennzeichnenden Merkmale gelöst. Vorteilhafte Weiterbildungen der erfinderischen Lösung ergeben sich aus den Unteransprüchen.

Die Erfindung beruht auf einem Baukastensystem, mit dem unterschiedliche Schaltschränke bzw. Schaltschrankanordnungen je nach Bedarf und Funktion realisiert werden. Der Baukasten ist dabei so gestaltet, dass mit wenigen Bausteinen, mit Schaltschranksegmenten oder Module, unterschiedliche Funktionen realisiert werden können. Die einzelnen Bausteine können somit in höherer Stückzahl und ggf. als Serienfertigung unter Einsatz von Automaten hergestellt und sogar bevorratet werden. Dies führt zu geringeren Herstellungskosten. Mit wenigen Bausteinen lassen sich somit unterschiedliche Schränke mit unterschiedlichen Funktionen kostengünstig und flexibel herstellen. Die Funktionen lassen sich zu einer entsprechenden Ordnung für die Bausteine darstellen.

Die Gesamtfunktion eines Schaltschrankes umfasst zum einen bestimmte Grundfunktionen, die immer wieder kehren und denen ein Grundbaustein in Form eines Grundmoduls zugeordnet ist. Des Weiteren Hilfsfunktionen, die anschließend oder verbindend wirken, und denen daher ein Hilfsbaustein als Hilfsmodul zugeordnet wird. Als weitere Teilfunktion der Gesamtfunktion sind Sonderfunktionen vorgesehen, die besonders ergänzend und erweiternd sind und denen daher ein Sondebaustein bzw. ein Sondermodul zugeordnet wird. Ferner umfasst die Gesamtfunktion noch Anpassfunktionen, die nicht genau in allen Teilen festlegbar sind und denen eine Anpassbaustein bzw. ein Anpassmodul zugeordnet wird.

Ergänzt werden kann das Baukastensystem zusätzlich durch ein sog. Mischsystem, das auftragsspezifische Funktionen beinhaltet, die nicht vorhersehbar sind und denen ein sogenannter "Nichtbaustein" bzw. ein Nichtmodul zuordbar ist.

Unterschiedliche Varianten der Gesamtfunktion eines Schaltschrankes können somit bestimmte Bausteine bzw. Schaltschranksegmente zugeordnet werden, die flexibel eingesetzt zu unterschiedlichen Schaltschränken führen. Die verschiedenen Bausteine oder Module können entsprechend ihrer oben erwähnten Funktion vorab gefertigt, ggf. bevorratet werden und flexibel zu einem Schaltschrank mit einer anderen Funktion zusammengebaut werden.

Aus dem Stand der Technik war es bisher nur bekannt, einem einzelnem Modul einen bestimmte Funktionsbaustein zu zuordnen und nicht - wie bei der Erfindung vorgeschlagen - das ein und dasselbe Modul oder Segment für unterschiedliche Funktionen verwendet werden kann.

Durch den flexiblen, modulartigen Aufbau des Schaltschrankes können die einzelnen Segmente bzw. Module an schwer zugänglichen Stellen z. B. oben in der Windenergieanlage, ohne großen Aufwand in der Nabe bzw. im Maschinenhaus einfacher zu einem Schaltschrank montiert bzw. später dann demontiert werden, da die einzelnen Segmente kleinere Abmessungen aufweisen als ein kompletter Schaltschrank. Dies wiederum bedingt neben den geringeren Herstellungs- und Wartungskosten auch eine höhere Verfügbarkeit der Anlage.

Vorzugsweise bestehen die Segmente und Module des Schaltschrankes aus Metall, insbesondere aus rostfreiem Edelstahl, aus beschichtetem Stahl oder aus einem anderen Material, wie zum Beispiel auch Kunststoff, welches für den Einsatz in Windenergieanlagen geeignet ist.

In einer vorteilhaften Ausführung sind mehrere unterschiedlche Segmente oder Module hintereinander und nebeneinander angeordnet. Sie bilden nebeneinander angeordnet einen kompakten, nach oben offenen kastenförmigen Schaltschrank. Quer dazu können durch eine Kombination von gleichen Segmente oder Modulen weitere kastenförmige Schaltschränke, jedoch mit einer unterschiedlichen Funktion, dargestellt werden. Die aus einer solchen Kombination entstanden Schaltschränke oder Schaltschrankanordnungen können dabei entweder direkt benachbart oder im Abstand zueinander angeordnet sein.

Vorteilhaft weist jedes Segmente und Modul einen eigenen Deckel auf, wobei selbstverständlich auch eine gemeinsame Abdeckung aller Segmente oder Module möglich ist. Der einzelne oder gemeinsame Deckel ist aus demselben Material oder einem anderen geeignetem Material gefertigt wie die einzelnen Module oder Segmente.

Im Rahmen des Baukastensystems ist es vorteilhaft die Anzahl der Segmente oder Module auf ein Minimum zu reduzieren. Für die vorgesehene Funktion des Schaltschrankes für den Pitchantrieb sind nur drei unterschiedliche Module oder Segmente erforderlich, ein Endkappenmodul, ein Außensegment und ein Mittelsegment. Die Segmente oder Module sind somit in einer ersten Ausführungsform der Erfindung der räumlichen Anordnung im Schaltschrank zuordbar.

In dem segment- oder modulartig aufgebauten Schaltschrank kann z.B. eine Endkappe als Montageplatte für die Montage von elektrischen Komponenten und Geräte des Schaltschrankes und deren Halterungen vorgesehen sein. Eine, der ersten Endkappe gegenüber liegende weitere Endkappe, könnte als Steckerfeld für den elektrischen Anschluss nach außen oder zu einem anderen, benachbarten Schaltschrank oder Schaltschankmodul vorgesehen sein. Die Endkappe des Steckerfeldes kann dabei flächenmäßige Ausstanzungen für die Anordnungen von Steckern oder Steckerfeldern auf seiner Oberfläche aufweisen. Sind keine oder nur ganz wenige Austanzungen erforderlich, ist diese Endkappe nahezu gleichartig aufgebaut wie ihre gegenüberliegende Montageplatte und kann dementsprechend auch als solche verwendet werden.

Die Anforderung des Bauskastensystems mit möglichst wenigen gleichen Bausteinen, vielfältige Funktion des Schaltschrankes umzusetzen, wird weiter vorteilhaft dadurch realisiert, dass die beiden Außensegmente und das von beiden eingeschlossene Mittelsegment in Ihrer Grundstruktur einen nahezu gleichen Aufbau aufweisen. Dies hat den Vorteil, dass ein und dasselbe Segment entweder als Außensegment oder als Mittelsegment einsetzbar ist. In einer weiteren Ausführung der Erfindung wird somit die räumliche Zuordnung der Segmente oder Module aufgehoben.

Ein Segment oder Modul besteht aus einer U-förmige flächige Rahmenkonstruktion mit einem horizontal sich erstreckenden rechteckigen geschlossenen oder offenen Bodenfläche, die von Rahmenteile umgeben ist und jeweils seitlich senkrecht aufragenden flächige Rahmenseitenteile aufweist. Das Mittelsegment ist an jeweils einem Längsrahmen- und Seitenrahmenteil mit den entsprechen Rahmenteile eines Außensegmentes verbunden ist.

Entsprechend ihrer Funktion und der Verwendung sind die U-förmigen Segmentteile (Außensegment und/ oder Mittelsegment) unterschiedlich breit ausgeführt.

Die beiden Außensegmente und das Mittelsegment unterscheiden sich ferner darin, das sie jeweils zum Teil offene und / oder geschlossene Grund- oder Seitenflächen aufweisen, je nach dem in welcher Funktion sie eingesetzt sind. Somit sind beide Segmente oder Module im Prinzip austauschbar, und können als ein einziges Bauteil hergestellt werden, das entsprechend seiner Verwendung durch ausstanzbare Öffnungen in den Seiten- oder in der Bodenfläche nur angepasst zu werden braucht.

Um die geschlossene Kastenform des Schaltschrankes zu realisieren, ist die nach außen weisende Fläche des Außensegmentes zwischen den beiden Rahmenseitenteile von jeweils einer Endkappe abdeckt. Die Seitenrahmenteile des Mittelssegmentes können beidseitig eine geschlossene Fläche bilden oder in seiner geschlossenen Bodenfläche Öffnungen aufweisen. In den Seitenwänden des Außensegmentes können z. B nachträglich durch Ausstanzungen offene Flächen erzeugt werden. In den ausgestanzten Öffnungen in einem der Seitenwände des Außensegmentes können Schalter oder Verbindungsteile oder andere elektrische Komponenten nach außen befestigt werden.

Mit dem Baukastensystem lassen sich mit den oben beschriebenen beiden Segmenten oder Modulen als Baustein auch vorteilhaft eine Schaltschrankanordnung realisieren, die mehrere einzelne Schaltschränke umfasst.

Mit den beiden Segmenten kann zum einem ein Umrichterschrank (Umrichterbox) hergestellt werden, in dem alle Geräte und Vorrichtungen für die Umrichtung des Stromes angeordnet sind, so wie sie in einem klassischen Schaltschrank vorgesehen sind. Dieser Schrank ist als Teilschrank separat herstellbar und kann somit separat oben in der Nabe oder in der Gondel der Windenergieanlage mit anderen Schränken durch Schrauben, Bolzen oder Nieten unterschiedlich kombiniert werden und später demontiert werden.

Mit den nahezu den gleichen Bauteilen wie die Umrichterbox kann aber auch ein Behältnis hergestellt werden, das nur wieder aufladbare Spannungsquellen in Form von Akkumulatoren oder Kondensatoren mit ihren zugehörigen Schaltungen umfasst, die eine Notstromversorgung bei Ausfall der Stromversorgung des Pitchantriebes sicherstellen, um die Rotorblätter sofort in eine Park- oder Fahnstellung zu drehen. Aus Sicherheitsgründen (Entgasung) ist eine solche "Akkubox" separat von denen der Umrichterbox vorgesehen.

In einer weiteren Ausführung sind also beide Boxen - und noch weitere Boxen zusätzlch, falls dies notwendig ist - im Prinzip aus nur einem Gleichteil aufgebaut, einem U-förmigen Segmentteil, das entweder als Außensegment oder als Mittelsegment einsetzbar ist.

Weitere Ausführungsarten und Variationen der Erfindung ergeben sich aus den Unteransprüchen und den im Folgenden dargestellten Ausführungsbeispielen in der Zeichnung.
Fig1 zeigt in einer perspektivischen Darstellung eine erste Ausführung der Erfindung.
Fig. 2 zeigt die Fig. 1 in einer Explositionsdarstellung.
Fig.3 zeigt in einer perspektivischen Darstellung eine weitere Ausführungsform der Erfindung.
Fig. 4 zeigt die Fig. 3 als offene Schaltschrankkombination.
Fig. 5 zeigt in einer schematischen Darstellung ein Baukastensystem mit zuordbaren Bausteinen für die Herstellung eines modularen Schaltschrankes.

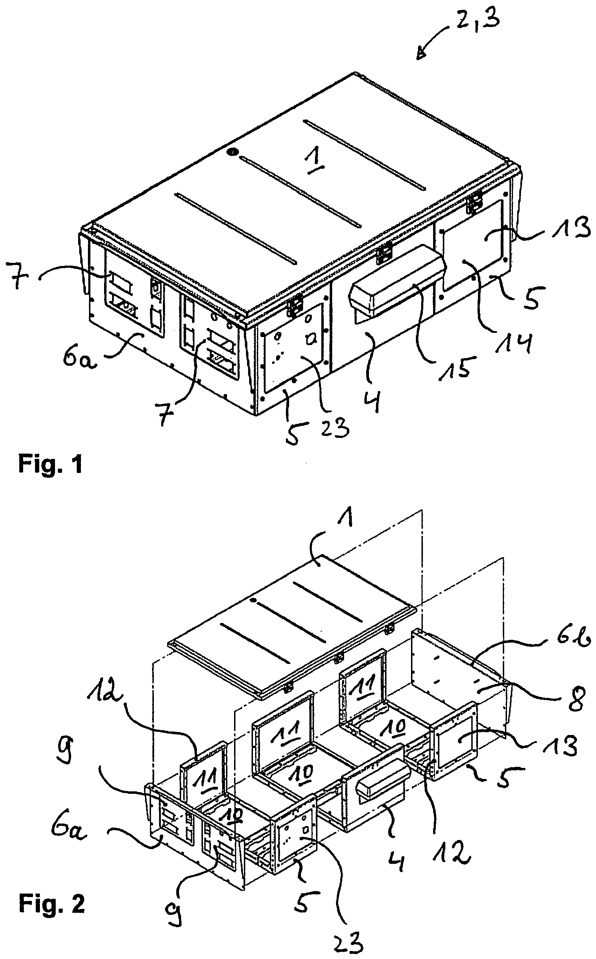

Fig. 1 zeigt einen mit einem Deckel 1 abgeschlossenen kastenförmigen ausgeführten elektrischen Schaltschrank 2, in dem nicht dargestellte elektrische Geräte und Schaltungen angeordnet sind, zur Steuerung eines Blattwinkelverstellantriebes (Pitchantrieb) einer Windenergieanlage (WEA), mittels dessen ein oder mehrere Rotorblätter der Anlage um ihre Blattachsen drehbar verstellbar sind. Wesentlicher Bestandteil eines solchen Schaltschrankes sind die elektronischen Umrichtereinheiten für den gesteuerten Antrieb des Pitchsystems. Daher werden diese Schränke auch als Umrichterbox 3 bezeichnet. Die Umrichterbox 3 umfasst z. B. elektrische oder elektronische Bauteile und Geräte, wie z.B. Netzteile, Leistungsschalter und Stecker, Ein-/ Ausgabeeinheiten, Sicherungen, Transformatoren und andere Teile und Geräte, die auch in einem klassischen Schaltschrank für einen elektrischen Antrieb vorgesehen sind.

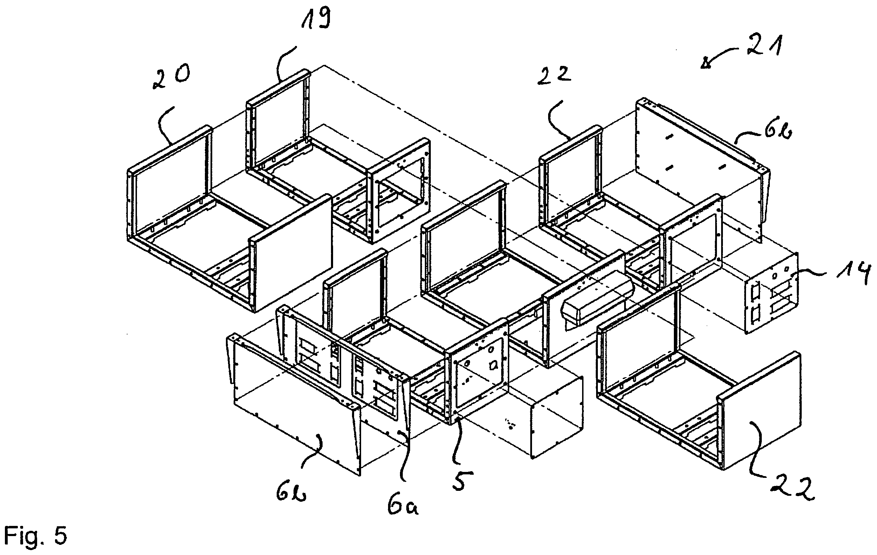

Die als elektrischer Schaltschrank fungierende Umrichterbox 3 ist aus drei Module oder Segmente eines Baukastensystems 21 zusammengesetzt, die hintereinander angeordnet sind. Die Module oder Segmente bilden somit Bausteine 22 des Baukastensystems 21. Die Struktur eines solchen Baukastensystems 21 mit einzelnen Bausteinen 22 ist aus der Fig. 5 ersichtlich.

Mit Hilfe des in Fig. 5 dargestellten Baukastens 21 ist in Fig. 1 und Fig. 2 eine Umrichterbox 3 zusammengesetzt worden. In der Mitte der Umrichterbox 3 ist - wie dies insbesondere aus Fig. 2 ersichtlich ist - ein U-förmiges Mittelsegment 4 angeordnet, das an seinem Seitenrand jeweils rechts und links mit jeweils einem ebenfalls U-förmigen Außensegment 5 verbunden ist. Beide Außensegmente 5 und das Mittelsegment 4 sind entlang Ihrer Längsseite über entsprechende Verbindungsmittel dicht, aber trennbar miteinander verbunden. Die beiden Außensegmente 5 und das sie einschließende Mittelsegment 4 sind im Wesentlichen gleich aufgebaut, wie dies ebenfalls aus Fig. 2 ersichtlich ist. Sie unterscheiden sich in der Ausführung als Umrichterbox 3 lediglich in ihrer Seitenlänge. Die beiden Außensegmenten 5 sind in der Ausführung nach Fig. 1 und Fig. 2 kürzer als das Mittelsegment 4. Sie können aber auch die gleiche Seitenlänge aufweisen wie das Mittelsegment 4.

Fig. 2 zeigt in einer Explositionsdarstellung den modularen Aufbau der Umrichterbox 3. Die beiden Außensegmente 5 werden an ihrer nach außen gerichteten Längsseite von jeweils einer Endkappe 6a, 6b abgedeckt, die somit den Kasten in Längsrichtung abschließen. Die beiden Endkappen sind ebenfalls nahezu gleichartig aufgebaut. Eine Kappe 6a, 6b umfasst eine Platte, deren Flächen je nach Anforderung ausstanzbar ist, so dass sie offene oder geschlossene Flächen bilden.

Bei der im vorderen Bereich der Fig. 2 dargestellte Endkappe 6a sind die Fläche in der Art zweier benachbarter Fenster 9 ausgestanzt. Jedes Fenster 9 umfasst ein Steckerfeld 7, in dem Stecker zum Anschluss für die Stromversorgung oder Kommunikation mit dem Pitchantriebes oder mit einer übergeordneten Steuerung der WEA angeordnet sind. Die hintere Endkappe 6b ist als Montageplatte 8 zum Anbringen von Geräten oder Schaltungen vorgesehen. Alternativ könnte für diese Kappe auch die nichtausgestanzte vordere Endkappe 6a verwendet werden.

Das U-förmige Mittelsegment 4 und die beiden Außensegmente 5 bestehen aus jeweils einer Bodenfläche 10 und senkrecht dazu seitlich aufragenden Seitenflächen 11. Die Bodenfläche und die beiden Seitenflächen werden durch Rahmenteile 12 begrenzt, die mit einander und mit dem Nachbarahmen (siehe Fig. 1) verbunden sind. In der Ausführung des Schaltschrankes 2 als Akkubox 3 sind alle Bodenflächen 10 geschlossen. Die Seitenflächen 11 weisen jedoch eine unterschiedliche Oberflächengestaltung auf. Die beiden hinteren Seitenflächen 11 der beiden Außensegmente 5 sind geschlossen, während ihre vorderen Seitenflächen 11 über ihre gesamte Fläche eine Öffnung 13 aufweisen, die jedoch mit einer ausstanzbaren Platte 14 verschlossen ist. Auf der Platte 14 des vorderen Außensegmentes 5 ist ein Schalterfeld 23 zum Montieren von Schaltern und ähnlichen Einrichtungen vorgesehen. Bei der vorderen Platte 14 (Fig. 1) des hinteren Außensegmentes 5 ist hingegen die Platte 14 nicht ausgestanzt. Die beiden Seitenflächen 14 des Mittelsegmentes 4 bilden vorne wie hinten eine geschlossene Fläche. Auf der vorderen Seitenfläche ist zusätzlich noch eine Beleuchtungseinrichtung 15 (Fig. 1) für die Nabe der Windenergieanlage angeordnet.

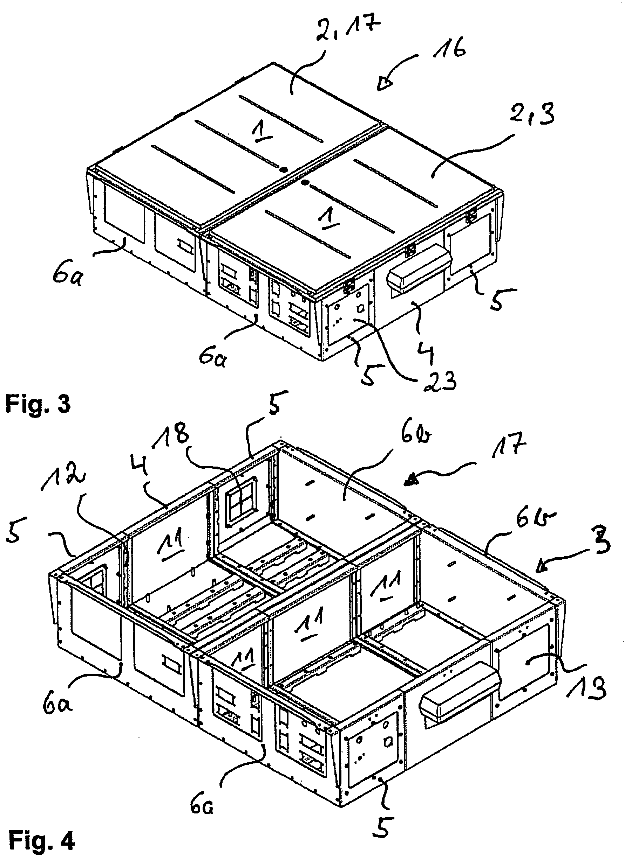

Fig. 3 zeigt eine aus einzelnen Modulen zusammengesetzte Schaltschrankanordnung 16, die aus einer Kombination von zwei hintereinander angeordneten Schaltschränken 2 besteht, die jeweils von einem Deckel 1 abdeckt sind.

Im weiteren Verlauf der Beschreibung werden identische oder gleichlautende Bauteile oder Funktionen mit denselben Bezugszeichen versehen.

Fig. 3 zeigt ein mit dem Baukastensystem 21 gemäß Fig. 5 hergestellte Schaltschrankanordnung 16 mit einem zusätzlichen Schaltschrank 2, der aus nahezu den gleichen Bausteinen 22, d.h. Segmenten und Module (4, 5) aufgebaut ist, wie die oben beschriebene Umrichter Box 3 aus Fig. 1 und Fig.2 . An der Umrichter Box 3 ist seitlich (in Fig. 3 und Fig. 4 links) eine weiterer Steuerschrank 2 angeordnet, der entsprechend dem Baukastensystem 21 der Fig. 5, aus nahezu den gleichen Segmenten oder Modulen zusammengesetzt ist wie die Umrichterbox 3.

Fig. 4 zeigt die Schaltschrankanordnung 16 der Fig. 3 ohne Deckel und ohne Inhalt, so dass der modulare Aufbau beider Schränke sichtbar wird.

Bei der zweiten Box 2 handelt sich um eine sog. Akkubox 17, einem Behältnis, in dem wieder aufladbare Gleichspannungsquellen in Form von Akkumulatoren (daher die Bezeichnung Akkubox) oder wieder aufladbaren Kondensatoren und deren Verschaltungen angeordnet sind. Aus Sicherheitsgründen müssen die Akkumulatoren in einem separaten Behältnis, der Akkubox 17, angeordnet sein. Die in der Akkubox 17 angeordneten Akkumulatoren (oder andere wieder aufladbare Spannungsquellen) haben die Aufgabe, bei Netzstörungen oder einem Netzausfall kurzfristige die Stromversorgung des zugehörigen Pitchantriebes sicherzustellen.

Der modulare Aufbau der Akkubox 17 ist nahezu identisch mit dem der benachbarten Umrichterbox 3. Aus Fig. 4 ist ersichtlich, dass die Akkubox 17 aus einem Mittelsegment 4 besteht, dem seitlich Außensegmente 5 zugeordnet sind. An den beiden Außenfläche des Außensegmentes 5 sind ebenfalls, wie bei der Umrichterbox 3, Endkappen 6a und 6b vorgesehen, wobei die vordere Abdeckplatte 6a analog zu der Umrichterbox 3 wieder zwei ausstanzbare Fensteröffnungen aufweisen, die jedoch im Gegensatz zu den beiden Fensteröffnungen 9 in der Umrichterbox 2 mit Ausnahme einer einzigen kleine Steckeröffnung für den Anschluss zur Umrichterbox 3 im linken Fenster verschlossen ist. Die hintere Endkappe 6b weist wie ihr Pendant in der Umrichterbox 3 eine durchgehende geschlossene Montageplatte 8 auf.

Wie bei der Umrichterbox 3 bestehen die beiden Außensegmente 5 und das Mittelsegmente 4 der Akkubox 17 aus einer U-förmigen Rahmenkonstruktion, deren Aufbau bereits beschrieben wurde. Die nach vorne gerichteten Seitenfläche 11 des Außensegmentes 5 weist ebenfalls wie bei der Umrichterbox 3 eine Öffnung 13 auf, die jedoch durch eine Platte 14 verschlossen ist. Die hintere Seitenfläche 11 der beiden Außensegmente 5 weist eine weitere Öffnung 18 für eine Klimatisierung des Akkuschrankes 17 auf. Das Mittelsegment 4 des Akkuschrankes ist identisch mit dem der Umrichterbox 3.

Sowohl für die Akkubox als auch für die Umrichterbox werden für deren Herstellung lediglich nur ein U-förmiges Segmentteil sowie jeweils Endkappen 6a und 6b und ein Deckel 1 benötigt. Mit diesen beiden Bausteinen 20 lassen sich somit unterschiedliche Schaltschrankanordnungen realisieren. Wird beispielsweise ein größerer Umrichter für eine andere Anwendung benötigt, wird ein größeres Mittelsegment engesetzt. Für den Schaltschrankbau ergeben sich somit kürzere Lieferzeiten aufgrund von öfters wieder kehrenden, gleichen Teilen.

Fig. 5 zeigt in einer schematischen Darstellung das oben bereits erwähnt Baukastensystem 21 mit zuordbaren Bausteinen 22 für die Herstellung eines modularen Schaltschrankes. Mit den in Fig. 5 dargestellten wenigen Module oder Segmente können unterschiedliche Schaltschränke bzw. Schaltschrankanordnungen je nach Bedarf und Funktion realisiert werden. Die Funktionen lassen sich zu einer entsprechenden Ordnung für die Bausteine ordnen.

Als ein erster Grundbaustein ist links oben in Fig. 5 ein mit dem Bezugszeichen 19 versehenes schmales und ein breites mit dem Bezugszeichen 20 versehenes U- förmiges Segment oder Modul dargestellt, wobei das kürzere Segment 20 in seinem Grundaufbau identisch ist mit dem Außensegment 5 der Anwendung als Akkubox 17 oder als Umrichterbox 3 und das breitere Segment 20 identisch ist mit dem Mittelsegment 4. Die Seitenflächen des Grundbausteines sind als Hilf-Sonder-, Anpassbauteil oder als Nichtbaustein ausgeführt, wie zum Beispiel das Steckerfeld 7, die Fensteröffnungen 9 und 13 oder die Platte 14 ausgeführt. Wie aus Fig. 5 weiter ersichtlich ist, können die beiden Grundbausteine in ihrer räumlichen Anordnung auch vertauscht werden, d.h. das bei der Akkubox als Mittelsegment 4 bezeichnete Baustein kann auch am Rand angeordnet sein, Desweitern kann ein in der Umrichterbox als Außensegment bezeichneter Baustein eine Mittelposition einnehmen.

Als weiterer Grundbaustein sind aus Fig. 5 noch die beiden Endkappe 6a und 6b ersichtlich. Jede Kappe besteht aus einer Platte, die jeweils nach Bedarf und Funktion ebenfalls als Hilf- Sonder-, Anpassbauteil oder als Nichtbaustein ausgeführt ist.

Ein Schaltschrank 2, der in der Nabe oder in der Gondel als Leitschrank - bzw- Leitbox fungiert, kann aus einer Kombination zweier kurzer U-förmiger Segmente oder zweier Grundbausteine 19 gemäß Fig. 5 zusammengesetzt werden. Diese entsprechen wiederum zweier Außensegmente 5 einer Umrichterbox 3. Durch ein modulares Aneinanderreihen von nur wenigen Teilsegmenten oder Modulen lassen sich somit unterschiedliche Kundenspezifikationen mit ein und demselben Baukasten darstellen.

## Patentansprüche

1. Verwendung eines Baukastensystem zur Herstellung einer Schaltschrankanordnung (16) mit mehreren einzelnen Schaltschränken, wobei jeder der Schaltschränke ein mit einem Deckel verschlossener, kastenförmiger und aus mindestens zwei Modulen bzw. Schaltschranksegmenten (4, 5) zusammengesetzter elektrischer Schaltschrank (2, 3, 17) ist, und jeweils einem Modul funktionsmäßig bestimmte elektrische Komponenten und Geräte zugeordnet sind, wobei einem Segment bzw. Modul (4, 5) jeweils unterschiedliche elektrische Komponenten und Geräte zugeordnet werden können bzw. zuordbar sind, mit denen - als Teilfunktion kombiniert - unterschiedliche Gesamtfunktionen bzw. Ausführungsformen jedes Schaltschrankes (2) realisiert werden können bzw. realisierbar sind, und wobei die Module oder Segmente Bausteine des Baukastensystems (21) bilden, **dadurch gekennzeichnet, dass**
- mehrere unterschiedliche der Bausteine (4, 5) seitlich zu einem der kastenförmigen Schaltschränke (2, 3, 17) angeordnet werden und quer dazu die gleichen Bausteine (4, 5) einen weiteren der kastenförmigen Schaltschränke (2, 17) mit unterschiedlichen Funktionen bilden,
- der eine Schaltschrank eine Umrichterbox (3) bildet, in der elektrische Geräte und Schaltungen zur Steuerung eines Blattwinkelverstellantriebs einer Windenergieanlage angeordnet werden, mittels welchem ein oder mehrere Rotorblätter der Anlage um ihre Blattachsen drehbar verstellbar sind, und
- der weitere Schaltschrank eine Akkubox (17) bildet, in die wieder aufladbare Gleichspannungsquellen in Form von Akkumulatoren oder wieder aufladbaren Kondensatoren und deren Verschaltungen angeordnet werden, mittels welchen Gleichspannungsquellen bei Netzstörungen oder einem Netzausfall kurzfristig die Stromversorgung des zugehörigen Blattwinkelverstellantriebs sicherstellbar ist.

2. Verwendung nach Anspruch 1, **dadurch gekennzeichnet, dass** die Segmente oder Module (4, 5) aus Metall bestehen.

3. Verwendung nach Anspruch 1 oder 2, **dadurch gekennzeichnet, dass** jedes Segment oder Modul (4, 5) einen eigenen Deckel (1) aufweist.

4. Verwendung nach Anspruch 1 oder 2, **dadurch gekennzeichnet, dass** die Segmente oder Module (4, 5) jedes Schaltschranks von einem gemeinsamen Deckel (1) abgedeckt sind.

5. Verwendung nach einem oder mehreren der Ansprüche 1 bis 4, **dadurch gekennzeichnet, dass** je Schaltschrank drei neben einander angeordnete unterschiedliche Segmente oder Module (4, 5) von dem Deckel (1) abdeckt sind und den jeweiligen Schaltschrank (2, 3, 17) bilden.

6. Verwendung nach einem oder mehreren der vorherigen Ansprüche, **dadurch gekennzeichnet, dass** die Segmente oder Module (4, 5) jedes Schaltschranks eine erste Endkappe (6a) und eine zweite Endkappe (6b), ein erstes und zweites Außensegment (5) und ein oder mehrere Mittelsegmente (4) aufweisen.

7. Verwendung nach Anspruch 6, **dadurch gekennzeichnet, dass** die beiden Endkappen (6a, 6b) jedes Schaltschranks flächenmäßig gleich groß sind, wobei die eine Endkappe (6a) eine Montageplatte für die Befestigung von elektrischen Komponenten und Geräten des jeweiligen Schaltschrankes und deren Halterungen und die andere Endkappe (6b) eine Platte mit einem Steckerfeld umfasst.

8. Verwendung nach Anspruch 6 oder 7, **dadurch gekennzeichnet, dass** die erste Endkappe (6a) jedes Schaltschranks flächenmäßige Ausstanzungen auf ihrer Oberfläche für die Anordnungen von Steckern oder Steckerfeldern oder anderen elektrischen Komponenten aufweist.

9. Verwendung nach einem oder mehreren der Ansprüche 6 bis 8, **dadurch gekennzeichnet, dass** ein Außensegment (5) und das Mittelsegment (4) jedes Schaltschranks im Wesentlichen den gleichen Aufbau aufweisen und untereinander austauschbar sind.

10. Verwendung nach einem oder mehreren der Ansprüche 6 bis 9, **dadurch gekennzeichnet, dass** ein Mittelsegment (4) und ein Außensegment (5) jedes Schaltschranks unterschiedlich breit sind.

11. Verwendung nach einem oder mehreren der vorherigen Ansprüche, **dadurch gekennzeichnet, dass** ein Segment bzw. Modul (4, 5) jedes Schaltschranks eine U-förmige flächige Rahmenkonstruktion umfasst mit einer horizontal sich erstreckenden rechteckigen Bodenfläche (10), die von Rahmenteilen umgeben ist, und die jeweils seitlich senkrecht aufragende flächige Seitenflächen (11) aufweist.

12. Verwendung nach Anspruch 11, **dadurch gekennzeichnet, dass** die Boden- und / oder Seitenflächen (10, 11) offene Flächen bzw. ausstanzbare Öffnungen aufweisen.

13. Verwendung nach einem der vorangehenden Ansprüche, **dadurch gekennzeichnet, dass** der eine Schaltschrank (3) separat hergestellt und in der Nabe oder in der Gondel der Windenergieanlage mit dem weiteren Schaltschrank (17) kombiniert wird.

## Claims

1. Application of a modular system to manufacture a switch cabinet assembly (16) with several individual switch cabinets, whereby each of the switch cabinets is a box-shaped electrical cabinet (2, 3, 17) closed by a lid and made up of at least two modules / switch cabinet segments (4, 5), with functionally determined electrical components and devices each assigned to one module, whereby different electrical components and devices can be assigned or are assignable to a segment or module (4, 5), with which - combined as a sub-function - different overall functions or embodiment forms for each switch cabinet (2) can be produced or are producible, and whereby the modules or segments form building blocks of the modular system (21), **characterized in that**
- Several different building blocks (4, 5) are arranged laterally next to one of the box-shaped switch cabinets (2, 3, 17), and transversely to this the same building blocks (4, 5) form a further box-shaped switch cabinet (2, 17) with different functions,
- one of the switch cabinets forms a converter box (3) in which electrical devices and circuits to control the blade angle adjustment drive of a wind turbine are arranged, by means of which one or more rotor blades of the turbine can be rotationally adjusted around their blade axis, and
- the additional switch cabinet forms a battery box (17) in which rechargeable direct voltage sources in the form of storage batteries or rechargeable capacitors and their associated circuits are arranged, by means of which direct voltage sources are able to secure the power supply to the associated blade angle adjustment drive rapidly in the event of grid disturbances or power failures.

2. Application in accordance with claim 1, **characterized in that** the segments or modules (4, 5) are made of metal.

3. Application in accordance with claim 1 or 2, **characterized in that** each segment or module (4, 5) has its own lid (1).

4. Application in accordance with claim 1 or 2, **characterized in that** the segments or modules (4, 5) of each switch cabinet are covered by a shared lid (1).

5. Application in accordance with one or more of claims 1 to 4, **characterized in that** in each switch cabinet, three different segments or modules (4, 5) arranged next to each other are covered by one lid (1) and form the respective switch cabinet (2, 3 17).

6. Application in accordance with one or more of the previous claims, **characterized in that** the segments or modules (4, 5) of a switch cabinet have a first end cap (6a) and a second end cap (6b), a first and second outer segment (5) and one or more middle segments (4).

7. Application in accordance with claim 6, **characterized in that** the two end caps (6a, 6b) of each switch cabinet are identically sized in terms of surface area, whereby end cap (6a) encompasses a mounting plate for the fixture of electrical components and devices for the respective switch cabinet and their fixtures, and the other end cap (6b) encompasses a plate with a connector field.

8. Application in accordance with claim 6 or 7, **characterized in that** the first end cap (6a) of each switch cabinet has punched surface area perforations over its surface for the arrangement of connectors or connector fields or other electrical components.

9. Application in accordance with several of the claims 6 to 8, **characterized in that** one outer segment (5) and the middle segment (4) of each switch cabinet have essentially the same structure and are interchangeable.

10. Application in accordance with one or more of the claims 6 to 9, **characterized in that** a middle segment (4) and an outer segment (5) of each switch cabinet have different widths.

11. Application in accordance with one or more of the above claims, **characterized in that** one segment or module (4, 5) of each switch cabinet encompasses a U-shaped flat framework construction with a rectangular floor surface (10) extending horizontally which is surrounded by frame components each comprising vertically upstanding flat side surfaces (11).

12. Application in accordance with claim 11, **characterized in that** the floor and/or side surfaces (10, 11) have open areas or punchable openings.

13. Application in accordance with one of the above claims, **characterized in that** one switch cabinet (3) is manufactured separately and combined with the other switch cabinet (17) in the hub or nacelle of the wind turbine.

## Revendications

1. Utilisation d'un système de construction modulaire pour la fabrication d'un agencement d'armoires de commande (16) avec plusieurs armoires de commandes différentes, chacune des armoires de commande étant une armoire de commande électrique (2, 3, 17) fermée par un couvercle, en forme de caisson et composée d'au moins deux modules ou segments d'armoire de commande (4, 5), et certains composants et appareils électriques sont affectés de manière fonctionnelle à un module, différents composants et appareils électriques pouvant être affectés ou étant affectables à un segment ou un module (4, 5), les différentes fonctions générales ou les différents modes de réalisation de chaque armoire de commande (2) pouvant être réalisés ou étant réalisables avec ces appareils et composants, combinés en tant que fonction partielle, et les modules ou segments formant des éléments constitutifs du système de construction modulaire (21), **caractérisée en ce que**
- plusieurs éléments constitutifs différents (4, 5) sont disposés sur le côté d'une des armoires de commande en forme de caisson (2, 3, 17) et de manière transversale à celle-ci les mêmes éléments constitutifs (4, 5) forment une autre des armoires de commande en forme de caisson (2, 17) dotée de fonctions différentes,
- l'une des armoires de commande forme un boîtier de convertisseur (3), dans lequel sont disposés des appareils et des circuits électriques pour la commande d'un dispositif d'entraînement de réglage d'angle de pale d'une éolienne, grâce auquel une ou plusieurs pales de rotor de l'éolienne sont réglables en rotation autour de leurs axes de pale, et
- l'autre armoire de commande forme un boîtier d'accumulateur (17), dans lequel sont disposés des sources de tension en courant continu rechargeables sous la forme d'accumulateurs ou des condenseurs rechargeables et leurs câblages, lesdites sources de tension en courant continu permettant de garantir à court terme l'alimentation électrique du dispositif d'entraînement de réglage d'angle de pale associé en cas d'incidents de réseau ou de panne de courant.

2. Utilisation selon la revendication 1, **caractérisée en ce que** les segments ou modules (4, 5) sont composés de métal.

3. Utilisation selon la revendication 1 ou 2, **caractérisée en ce que** chaque segment ou module (4, 5) présente son propre couvercle (1).

4. Utilisation selon la revendication 1 ou 2, **caractérisée en ce que** les segments ou modules (4, 5) de chaque armoire de commande sont recouverts par un couvercle commun (1).

5. Utilisation selon une ou plusieurs des revendications 1 à 4, **caractérisée en ce que** trois segments ou modules (4, 5) différents juxtaposés par armoire de commande sont recouverts par le couvercle (1) et forment chaque armoire de commande (2, 3, 17).

6. Utilisation selon une ou plusieurs des revendications précédentes, **caractérisée en ce que** les segments ou modules (4, 5) de chaque armoire de commande présentent un premier embout (6a) et un second embout (6b), un premier et un second segment externe (5) et un ou plusieurs segments centraux (4).

7. Utilisation selon la revendication 6, **caractérisée en ce que** les deux embouts (6a, 6b) de chaque armoire de commande présentent une surface de même taille, l'un des embouts (6a) comportant une plaque de montage pour la fixation de composants et d'appareils électriques de chaque armoire de commande et de ses fixations et l'autre embout (6b) comprenant une plaque dotée d'un panneau enfichable.

8. Utilisation selon la revendication 6 ou 7, **caractérisée en ce que** le premier embout (6a) de chaque armoire de commande présente des découpes planes sur sa surface pour disposer des fiches ou des panneaux enfichables ou d'autres composants électriques.

9. Utilisation selon une ou plusieurs des revendications 6 à 8, **caractérisée en ce qu'**un segment externe (5) et le segment central (4) de chaque armoire de commande présentent essentiellement la même structure et sont interchangeables.

10. Utilisation selon une ou plusieurs des revendications 6 à 9, **caractérisée en ce qu'**un segment central (4) et un segment externe (5) de chaque armoire de commande présentent une largeur différente.

11. Utilisation selon une ou plusieurs des revendications précédentes, **caractérisée en ce qu'**un segment ou un module (4, 5) de chaque armoire de commande comprend une construction de cadre plane en forme de U avec une surface au sol rectangulaire (10) s'étendant de manière horizontale, qui est entourée de pièces de cadre, et qui présente des surfaces latérales planes (11) se dressant verticalement sur les côtés.

12. Utilisation selon la revendication 11, **caractérisée en ce que** les surfaces au sol et/ou latérales (10, 11) présentent des surfaces ouvertes ou des ouvertures pouvant être découpées.

13. Utilisation selon l'une des revendications précédentes, **caractérisée en ce que** l'une des armoires de commande (3) est fabriquée séparément et combinée à l'autre armoire de commande (17) dans le moyeu ou la nacelle de l'éolienne.
